# EUROPEAN PATENT APPLICATION

(11) **EP 2 597 647 A1**
(43) Date of publication of application: **29.05.2013**
(21) Application number: 12192725.5
(22) Date of filing: 15.11.2012
(51) Int. Cl.: G11C 13/00

(54) **Selector device for memory applications**

(30) Priority: 28.11.2011 US 201161564048 P
(71) Applicant: IMEC, 3001 Leuven (BE); Katholieke Universiteit Leuven, 3000 Leuven (BE)
(72) Inventor: Martens, Koen, B-3001 Leuven (BE); Radu, Iuliana, B-3001 Leuven (BE); Cosemans, Stefan, B-3001 Leuven (BE); Blomme, Pieter, B-3001 Leuven (BE)
(74) Representative: Sarlet, Steven Renaat Irène

(57) **Abstract**

Selector device for selecting a memory element in a memory array comprising an MIT element comprising a MIT material component and a barrier component, and a decoupled heater, thermally linked to the MIT element, wherein the MIT element is switchable from a high to a low resistance state by heating the MIT element above a transition temperature with the decoupled heater, wherein the barrier component is provided to increase the resistance of the MIT element in the high resistance state.

## Description

### Technical field

The present disclosure relates to a selector device for memory applications.

### Background art

A cross-bar array is one of the densest schemes in which to organize a memory array. This can be used for RRAM (Resistive Random Access Memory), PCRAM (Phase Change RAM) , CBRAM (Conductive Bridging RAM) and other types of memory elements. In order to use a cross-bar array, a selector element is needed which allows for reading, writing, and erasing a chosen element or a row of elements by preventing unintended currents through unselected elements and allowing currents through the selected element. Further, the appropriate configuration of the selector element within the cross-bar array to realize a selector functionality is important to allow proper functioning of the cross-bar array. These considerations also hold for three-dimensional cross-bar architectures, such as, for example, BICS (Bit Cost Scaling).

The criteria to realize a selector element for the above-mentioned arrays are strict and a challenge to realize. For example, off-resistance needs to be sufficiently high in order to suppress unintended leakage currents through non-selected elements and on-resistance needs to be sufficiently low in order to avoid large voltage biases across selector devices when the element is selected. The switch from on to off must be as abrupt as possible. The device must be compatible with the cross-bar array processing and, in some cases, also compatible with three-dimensional stacking. In addition, the device should be realizable in as little process steps as possible.

Among the known selector solutions are conventional semiconductor diodes. These are, however, not compatible with bipolar RRAMs and do not have a sufficiently steep/abrupt change in current with voltage. Alternatively, MOSFETs allow abrupt switching because of the third terminal but will require more space in the array. Punch-through diodes (e.g., bipolar) or pinch-off FETs are also possible solutions. However, these solutions require the integration of a relatively complex extra device into the memory array. A more suitable selector is thus desirable.

### Summary of the disclosure

Disclosed are selector devices for memory elements. In one embodiment, the selector device comprises an MIT element comprising an MIT material component and a barrier component, and a decoupled heater, wherein the decoupled heater has a lower resistance than the MIT element in the off state and is thermally linked to the MIT element.

In some embodiments, the barrier component is selected to increase the resistance of the MIT element while preserving the abrupt resistance switch of the MIT element at the transition temperature.

In some embodiments, the selector device further comprises electrode(s).

In some embodiments, the MIT material component is an n-type MIT material or a p-type MIT material.

In some embodiments, the barrier component is selected to form a potential barrier for electrons for an n-type MIT material.

In some embodiments, the barrier component is selected to form a potential barrier for holes for a p-type MIT material.

In some embodiments, the MIT material comprises VO₂.

In some embodiments, the MIT material further comprises dopants.

In some embodiments, the barrier material is selected from the group consisting of SiO₂, HfO₂, ZrO₂ and mixtures or combinations thereof.

In some embodiments, the decoupled heater is thermally linked to a plurality of MIT elements.

In some embodiments, the heater is integrated in the word or bit line or positioned alongside the word or bit line as a separated word or bit line heater.

Also disclosed is a memory element joined with any of the above-described selector devices.

Also disclosed is an array of memory elements joined with any one of the above-described selector devices.

Also disclosed is a memory device comprising any of the above-described selector devices.

### Brief description of the drawings

The disclosure will be further elucidated by means of the following description and the appended figures.

All drawings are intended to illustrate some aspects and embodiments of the present disclosure. The drawings described are only schematic and are non-limiting.
Figure 1 is a schematic circuit representation of a metal-insulator-transition-based selector in a cross-bar array, in accordance with an embodiment.
Figure 2 is a schematic circuit representation of a first example circuit, in accordance with an embodiment.
Figure 3 is a schematic circuit representation of a second example circuit, in accordance with an embodiment.
Figure 4 is a schematic circuit representation of a third example circuit, in accordance with an embodiment.
Figure 5 is a schematic representation of a cross-section of a device that forms a part of a first example cross-bar array, in accordance with an embodiment.
Figure 6 is a schematic representation of a cross-section of a device that forms a part of a second example cross-bar array, in accordance with an embodiment.
Figure 7 is a schematic representation of a cross-section of a device that forms a part of a third example cross-bar array, in accordance with an embodiment.
Figure 8 is a schematic representation of a first example metal-insulator-transition-based selector in a three-dimensional resistive random access memory architecture called bit cost scaling, in accordance with an embodiment.
Figure 9 is a schematic representation of a second example metal-insulator-transition-based selector in a three-dimensional resistive random access memory architecture called bit cost scaling, in accordance with an embodiment.
Figure 10 is a schematic representation of a third example metal-insulator-transition-based selector in a three-dimensional resistive random access memory architecture called bit cost scaling, in accordance with an embodiment.

### Detailed description of preferred embodiments

The present disclosure will be described with respect to particular embodiments and with reference to certain drawings but the disclosure is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the disclosure.

Furthermore, the terms first, second, third and the like in the description and in the claims, are used for distinguishing between similar elements and not necessarily for describing a sequential or chronological order. The terms are interchangeable under appropriate circumstances and the embodiments of the disclosure can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the disclosure described herein can operate in other orientations than described or illustrated herein.

Furthermore, the various embodiments, although referred to as "preferred" are to be construed as exemplary manners in which the disclosure may be implemented rather than as limiting the scope of the disclosure.

The term "comprising", used in the claims, should not be interpreted as being restricted to the elements or steps listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising A and B" should not be limited to devices consisting only of components A and B, rather with respect to the present disclosure, the only enumerated components of the device are A and B, and further the claim should be interpreted as including equivalents of those components.

Disclosed is a selector for a cross-bar array architecture for memory elements with a configuration of elements in addition to the memory elements and word and bit lines.

In one embodiment, the selector may include a metal-to-insulator (MIT) element in combination with a decoupled heater. The MIT element may comprise an MIT material component and a barrier component that serves to increase the resistance of the MIT element while preserving (not influencing) the fact that the resistance of the element switches abruptly near the transition temperature of the MIT element.

In general, MIT materials have resistivities that are too low to allow them to serve as selector elements. By increasing the resistance of the MIT element with the introduced barrier component, however, the resistance of the MIT element in the off state (referred to also as the low temperature state) is increased, which is beneficial for reducing/suppressing the unintended leakage currents through non-selected elements.

Further, the MIT element of the disclosure is switched between high and low resistance states by heating it above the transition temperature with a decoupled heater. The MIT element is not self-heated (e.g., Joule heated by running an electrical current through the MIT element itself) because the required high resistance in the off state of the MIT element to limit leakage does not allow to heat at voltages commonly used in microelectronic applications (1-3V up to 12V). Therefore the MIT element is heated by a decoupled heater.

In different embodiments, the selector of the disclosure comprises a MIT element and a decoupled heater. The MIT element comprises an MIT material component and a barrier component. The MIT material may be, for example, a material that shows a first-order phase transition at a certain temperature, the transition temperature. The transition occurs when the temperature is changed and results in an abrupt change in resistivity and an abrupt change in density of free charge carriers. The material has a higher resistivity below the transition temperature. In some embodiments, the MIT material can be a semiconductor in the low temperature state even though it is referred to as "insulator" in "metal-to-insulator transition".

The MIT material component is contained between two electrodes and is represented as a 2-terminal temperature dependent resistor element. These electrodes could be part of a word line or bit line interconnect, the neighboring memory element, a heater, other part of the memory array or separately introduced electrode materials that connect the MIT element with interconnects, heaters, memory elements, or other parts of the memory array. Further, a barrier layer (also referred to as barrier component) is added between the MIT material component and one or both of the electrode(s) to increase the electrical resistance of the MIT element in the off state.

The barrier component is made of a barrier material selected such that it forms a potential barrier for electrons for an n-type MIT material (dominant free charge carrier type in the low temperature state of the MIT material are electrons) and a potential barrier for holes for a p-type MIT material (dominant free charge carrier type in the low temperature state of the MIT material are holes).

The tunneling and thermionic emission mechanisms that allow current through the barrier layer depend on the density of free charge carriers of the MIT material. Hence when the MIT material changes state from the low temperature to the high temperature state the density of free charge carriers in the MIT material increases abruptly and also the current through the barrier is modulated. Hence the barrier allows a higher resistance element which switches abruptly in resistance with temperature in the same way as the MIT material itself switches bulk resistivity with temperature.

An example of an MIT material which could be used is vanadium dioxide or doped vanadium dioxide. The MIT material is integrated in a memory element and the MIT material could also serve as electrode for the memory element and vice versa.

Advantageously, the MIT material and barrier layer can also be inserted in a BICS type three-dimensional architecture or other types of three-dimensional architectures for RRAM and other types of memories.

The barrier layer of the disclosure can be inserted by means of deposition, growth, chemical treatment, annealing or by omitting certain procedures to remove naturally forming barrier layers (e.g., oxides) on the MIT material or the electrode.

The selector of the disclosure further comprises a decoupled heater. Thus, the MIT element (consisting of the MIT material component and the barrier component) is not Joule heated by running a current through the MIT element itself, since the resistance of the MIT element in the off state would be too high to heat it with a voltage in the common microelectronics range (1-3V up to 12V). Instead, the MIT element of the disclosure is heated by a decoupled heater element with a lower resistance than the MIT element which is located in the vicinity of the MIT element and is heated by an electrical current of which the dominant part does not run through the MIT element. There is a high thermal conductance between the heater and the MIT element such that both elements are thermally linked to efficiently transfer heat to the MIT element or set of MIT elements. The heater may function with Joule heating or may alternatively be implemented with a thermoelectric element.

Heating any unintended elements can be avoided by providing sufficient thermal isolation. The heater can be provided for each MIT element or can be provided for sets of MIT elements. Alternatively, the heater can also be integrated in the word line. The word line itself could be heated by running a current through it or the word line could be heated by an electrically insulating but thermally conductive heater along the word line to avoid any voltage drops in the word line due to the higher heater currents. Examples of an electrically insulating but thermally conducting material are Al₂O₃ or HfO₂.

An MIT element can be provided for each memory element or an MIT element could be provided for sets of memory elements. In specific embodiments the MIT element can be integrated in the word line.

Further herein the 'on voltage' and the transition temperature are discussed briefly. The voltage across the heater at which the MIT element(s) are turned on or change(s) to the low resistance state is called the 'on voltage'. The decoupled heater allows selecting the heater resistance in order to tune the on voltage of the selector. The voltage applied across the heater can be chosen and adapted to the ambient temperature to compensate for the change in heat energy delivered to the MIT element with ambient temperature.

The heat drained to the ambient (and hence not used to heat the MIT element) is proportional to the difference between the local temperature and the ambient temperature (the higher the ambient temperature the less energy is needed to heat the MIT element to the transition temperature). Hence the ambient temperature will affect the on voltage. If the on voltage rises above the voltage applied across the heater to select, the selector no longer functions. Hence to ensure functionality across the operating temperature range the applied voltage should be larger than the on voltage for all temperatures in the operating temperature range.

Adapting the voltage applied across the heater with ambient temperature by keeping it close to the 'on voltage' and above the 'on voltage' allows minimizing the energy needed to turn the MIT element on by avoiding overheating the MIT element too much above the transition temperature. This also reduces potential thermal cross talk. Since the on voltage is also determined by the transition temperature of the MIT material, increasing the transition temperature will decrease the sensitivity of the on voltage to the ambient temperature. For a higher transition temperature a change in ambient temperature will lead to a smaller change in 'on voltage'.

In general the transition temperature of the MIT material will need to be above the chosen operating temperature range of the device since it should only be turned on by intentional heating. Choosing the transition temperature of the MIT material sufficiently high above the operating temperature range will reduce or eliminate the need to adapt the on voltage with ambient temperature. The transition temperature is sufficiently high when no large change of the MIT element resistance (resulting in incompliance with the off resistance selector specification) has occurred at the highest temperature of the operating temperature range compared to the reference ambient temperature, room temperature. For VO₂ the transition temperature can, for example, be raised by means of doping.

The solution is compatible with bipolar RRAMs given that the MIT element and its barrier are chosen so the on and off resistances for both polarities fulfill the requirements needed by the chosen memory element and cross bar array configuration.

Both the MIT element of the disclosure and the decoupled heater are easily scalable, fast, low energy and compatible with 3D architectures.

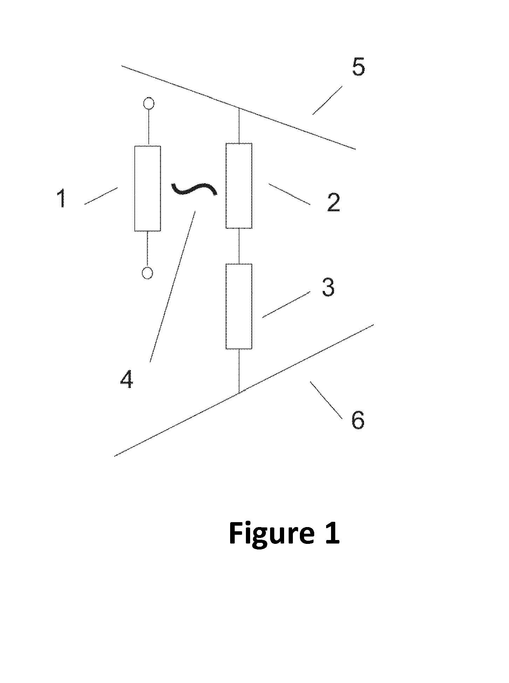

Figure 1 is a schematic circuit representation of a metal-insulator-transition-based (MIT-based) selector in a cross-bar array, in accordance with an embodiment. As shown, the cross-bar array includes a decoupled heater (1); an MIT element with engineered barrier (2); a memory element (3); a symbol of thermal link between decoupled heater and MIT element (4); a word line (5), and a bit line (6).

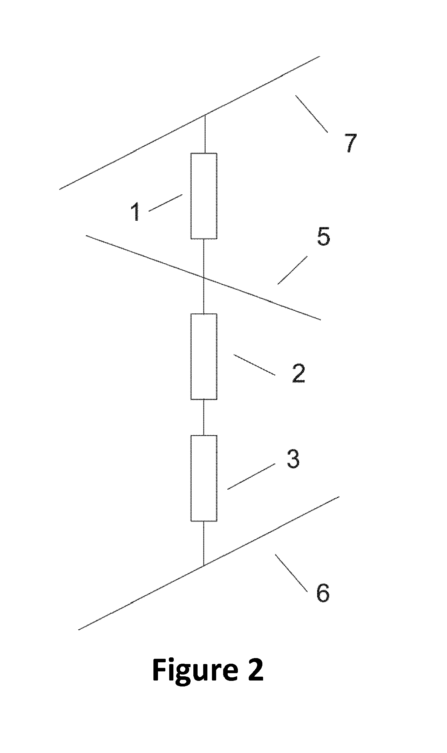

Figure 2 is a schematic circuit representation of a first example circuit, in accordance with an embodiment. As shown, the circuit includes all of the elements of that shown in Figure 1, as well as an extra line (7) provided for the heater (1).

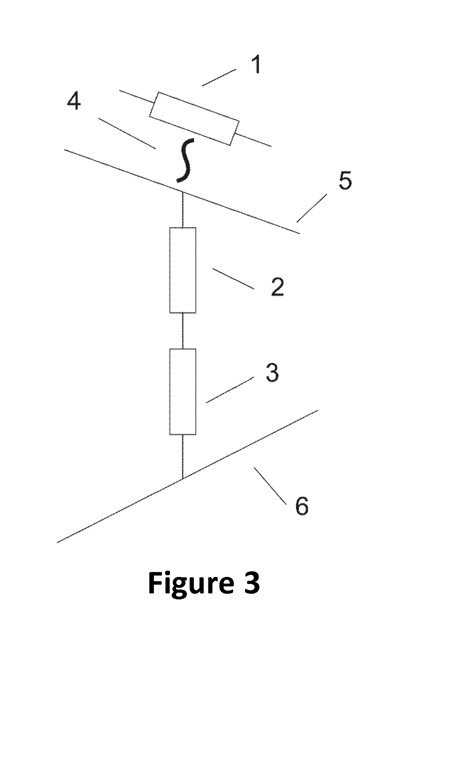

Figure 3 is a schematic circuit representation of a second example circuit, in accordance with an embodiment. Specifically, in this embodiment the heater heats up the word line and the heater is located alongside it. In this embodiment all or a part of the elements on the word line are selected simultaneously. The references are the same as in Figure 1.

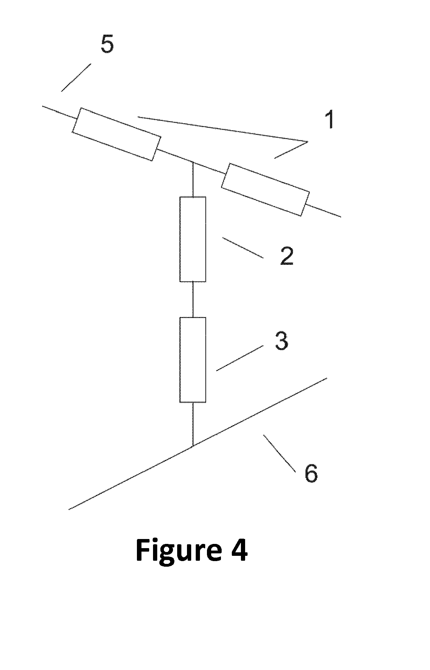

Figure 4 is a schematic circuit representation of a third example circuit, in accordance with an embodiment. In this case the word line itself also functions as the heater. All or some of the elements on the word line are heated simultaneously. The references are the same as in Figure 1.

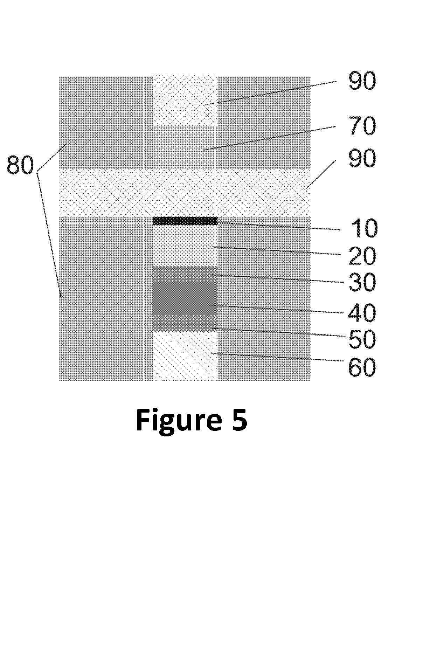

An example implementation of a first embodiment is a memory element attached to an MIT selector element joined with one decoupled heater in a 2D cross bar array. Figure 5 is a schematic representation of a cross-section of a device that forms a part of a first example cross-bar array, in accordance with an embodiment. As shown in Figure 5, the device includes (10) a layer comprising the barrier material of the MIT element; (20) a layer comprising the MIT material of the MIT element; (30) optional top electrode comprising a conductive material such as e.g. TiN for RRAM; (40) a layer comprising the memory material, e.g. a dielectric material such as HfO₂ or TiO₂ for RRAM; (50) an optional bottom electrode comprising a conductive material such as Hf or TiN for RRAM; (60) the bit line conductor which can be made of, e.g., Al or Cu in addition to possible interconnect liners such as e.g Ti/TiN; (70) a layer comprising a heater material of chosen resistivity and heat conductivity for optimal heating function; (80) electrically and thermally isolating dielectric material such as e.g. SiO₂, a low-k dielectric material or also air or vacuum; (90) the heater line conductor consisting of a conductor with relatively low thermal conductivity.

In between and on the area of the intersection of the crossed bottom bit line and top word line there is a stack of an optional bottom electrode material (e.g. TiN for RRAM), the memory material (e.g. HfO₂ or TiO₂ RRAM dielectric), an optional top electrode material (e.g. TiN or Hf for RRAM), the MIT material and the barrier material. On top of the word line on the intersection area of the crossing bit and word line the heater is formed of a material having a chosen resistivity and heat conductivity for optimal heating function. Crossed with the word line and on top of the heater the heater line is formed consisting of a conductor with relatively low thermal conductivity such as some metals with lower thermal conductivity. Also the word line consists of a material with relatively low thermal conductivity. The structure is surrounded by electrically and thermally isolating dielectric material such as e.g. SiO₂, a low-k dielectric or also air or vacuum.

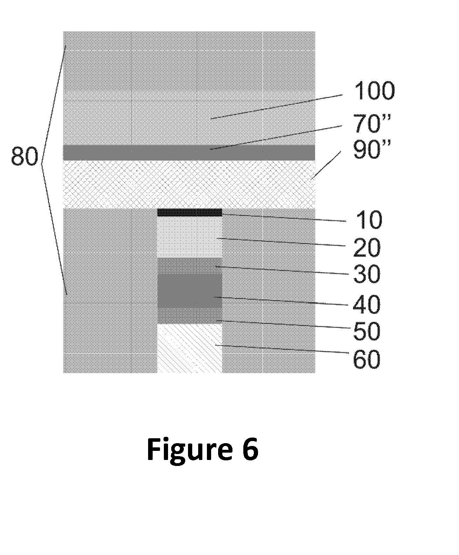

An example implementation of the second embodiment is a memory element attached to an MIT element with a separated word line heater. Figure 6 is a schematic representation of a cross-section of a device that forms a part of a second example cross-bar array, in accordance with an embodiment. As shown in Figure 6, the device includes (10) a layer comprising the barrier material of the MIT element; (20) a layer comprising the MIT material of the MIT element; (30) an optional top electrode comprising a conductive material such as e.g. TiN for RRAM; (40) a layer comprising the memory material which for RRAM would be a dielectric material such as HfO₂ or TiO₂; (50) an optional bottom electrode material comprising a conductive material such as Hf or TiN for, e.g., RRAM; (60) the bit line conductor which can be made of, e.g., Al or Cu in addition to possible interconnect liners such as e.g Ti/TiN; (70") a layer comprising an electrically isolating but thermally well conducting material such as e.g. Al₂O₃ or HfO₂; (80) Electrically and thermally isolating dielectric material such as e.g. SiO₂, a low-k dielectric material or also air or vacuum; (90") Word line conductor; (100) Separated word line heater consisting of a material having an electrical resistivity and heat conductivity for optimal heating functionality.

In this implementation, the heater is positioned on top of the word line separated from the word line with an electrically insulating but thermally well conducting layer such as a layer comprising HfO₂ or Al₂O₃. This implies that all the elements linked to the word line will be heated/selected. The word line can be segmented such that only parts of the word line are heated/selected. The advantage of this implementation is the increased thermal isolation of the heater from the elements of a different word line and improved thermal cross talk in general. The voltage drop across the heater does not induce a change in voltage across the memory element and the heater resistance can be optimized for heating separately from the word line resistance.

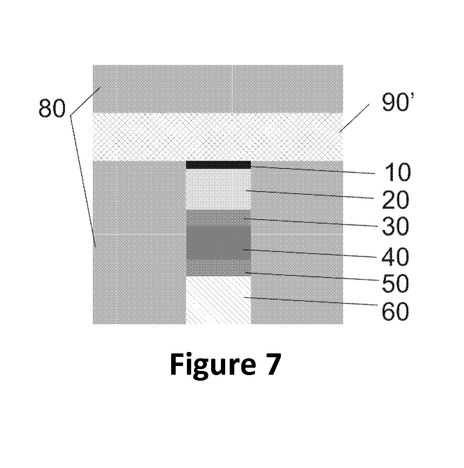

Another example implementation of a third embodiment is a memory element coupled/joined with an MIT element linked with a word line heater. Figure 7 is a schematic representation of a cross-section of a device that forms a part of a third example cross-bar array, in accordance with an embodiment. As shown in Figure 7, the device includes (10) a layer comprising the barrier material of the MIT element; (20) a layer comprising the MIT material of the MIT element; (30) an optional top electrode comprising a conductive material such as e.g. TiN for RRAM; (40) a layer comprising the memory material which for RRAM would be a dielectric material such as HfO₂ or TiO₂; (50) an optional bottom electrode material comprising a conductive material such as Hf or TiN for RRAM; (60) the bit line conductor which can be made of e.g. Al or Cu in addition to possible interconnect liners such as e.g Ti/TiN; (80) electrically and thermally isolating dielectric material such as e.g. SiO₂, a low-k dielectric material or also air or vacuum' and (90') the word line conductor which also serves as heater.

Instead of the heater added on top of the word line as in the previous embodiment the word line now functions as the heater. The additional heater line interconnect and heater are eliminated which will save a considerable amount of process steps. However, the voltage drop in the word line must be minimized in order not to induce a significant change in voltage across the selected memory elements so as not to influence the intended read/write/erase operations.

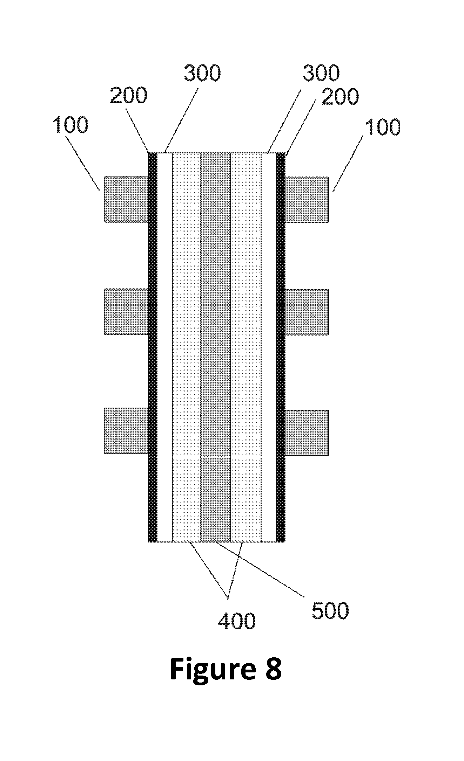

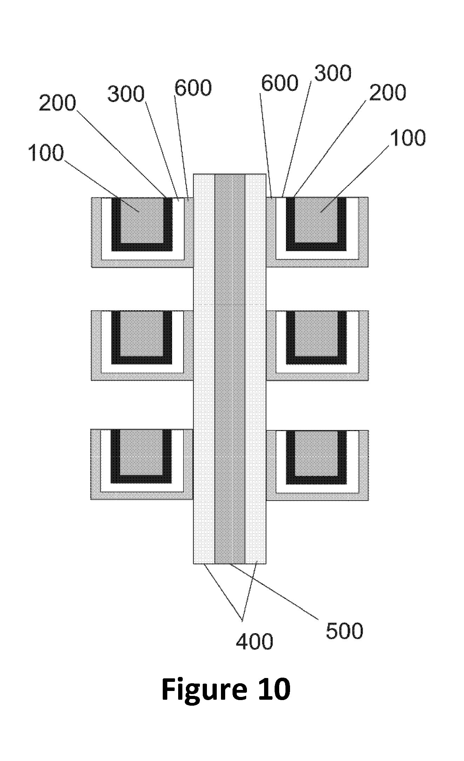

Figures 8, 9, and 10 are schematic representations of first, second, and third, respectively, example metal-insulator-transition-based selectors in a three-dimensional resistive random access memory architecture called bit cost scaling, in accordance with embodiments. As shown, an MIT-based selector is implemented in a three-dimensional BICS (Bit Cost Scaling) architecture with a vertical bit line. The word line can be heated as depicted in Figure 8 and 10.

In Figure 8, the cross section of part of a vertical bit line (500) and surroundings is schematically represented, where (400) RRAM material; (300) MIT material; (200) barrier material to modulate the switching resistance of the MIT element; (100) cross section of word lines. In this example the word line itself is heated. In the example illustrated in figure 8 the barrier layer is closest to the word line.

In Figure 10, the possible parasitic current running in the MIT material in the low temperature state between different levels is reduced. An additional electrode material (600) can be inserted.

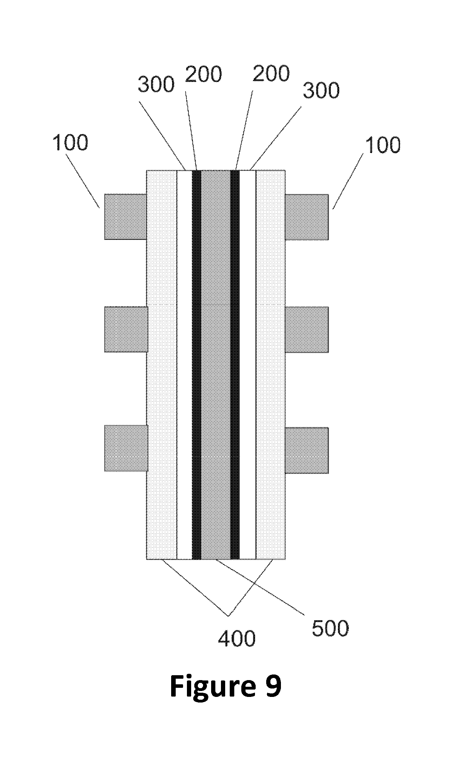

Alternatively, the bitline can be heated as depicted in Figure 9. In this example the barrier layer is located close to the bitline. Similar to the two-dimensional cases a separated heater could be added in parallel to the word (or bit) lines in a three-dimensional analogy of the two-dimensional scheme depicted in Figure 6. This parallel heater would be separated from the word line by an electrical insulator which is a good thermal conductor.

## Claims

1. Selector device for selecting a memory element in a memory array comprising an MIT element comprising a MIT material component and a barrier component, and a decoupled heater, thermally linked to the MIT element,
- wherein the MIT element is switchable from a high to a low resistance state by heating the MIT element above a transition temperature with the decoupled heater,
- wherein the barrier component is provided to increase the resistance of the MIT element in the high resistance state.

2. Selector device according to claim 1, wherein the decoupled heater has a lower resistance than the MIT element in the high resistance state.

3. Selector device according to any one of the preceding claims, wherein the MIT material component is an n-type MIT material.

4. Selector device according to any one of the preceding claims, wherein the MIT material component is a p-type MIT material.

5. Selector device according to claim 3, wherein the barrier component is selected to form a potential barrier for electrons for an n-type MIT material.

6. Selector device according to claim 4, wherein the barrier component is selected to form a potential barrier for holes for a p-type MIT material.

7. Selector device according to any one of the preceding claims, wherein the MIT material comprises VO₂.

8. Selector device according to any one of the preceding claims, wherein the MIT material further comprises dopants.

9. Selector device according to any one of the preceding claims, wherein the barrier component comprises a barrier material selected from the group consisting of SiO₂, HfO₂ or ZrO₂ and mixtures or combinations thereof.

10. Selector device according to any one of the preceding claims, wherein the decoupled heater is thermally linked to a plurality of MIT elements.

11. Selector device according to any one of the preceding claims, wherein the decoupled heater is integrated in a word line or bit line or positioned along a word line or bit line.

12. Selector device according to claim 11, wherein the decoupled heater comprises Al₂O₃ or HfO₂.

13. Memory element joined with at least one of the selector devices according to any one of the preceding claims.

14. Array of memory elements joined with at least one of the selector devices according to any one of the preceding claims.

15. Memory device comprising at least one of the selector devices according to any one of the preceding claims.
